# EUROPEAN PATENT APPLICATION

(11) **EP 0 908 953 A1**
(43) Date of publication of application: **14.04.1999**
(21) Application number: 97116111.2
(22) Date of filing: 16.09.1997
(51) Int. Cl.: H01L 25/075, B41J 2/45

(54) **Light emitting element module and chip**

(71) Applicant: Oki Electric Industry Co., Ltd., Tokyo (JP)
(72) Inventor: Taninaka, Masumi, 7-12, Toranomon 1-chome, Minato-ku Tokyo (JP); Ogihara, Mitsuhiko, 7-12, Toranomon 1-chome, Minato-ku Tokyo (JP); Shimizu, Takatoku, 7-12, Toranomon 1-chome, Minato-ku Tokyo (JP)
(74) Representative: Betten & Resch

(57) **Abstract**

In a light emitting element module (100, 60) in which plural chips (10, 50) each including plural light emitting elements (12, 52) are arranged on a board, when one side surface (10a, 50a) of each chip is expressed as a first side surface and another side surface of the chip which intersects to the first side surface is expressed by a second side surface, light emitting elements are located aside to and in the vicinity of the first side surface on the surface of the chip and arranged along the first side surface of said chips, and the chips are arranged on the board so that at least two chips are displaced from each other to the right and left sides with respect to the chip alignment. Particularly, the plural chips may be disposed in a staggered arrangement on a board.

## Description

### BACKGROUND OF THE INVENTION

### 1. Field of the Invention

The present invention relates to light emitting element modules and chips.

### 2. Description of the Related Art

There has been known one type of light emitting element module in which a plurality of a rectangular-parallelepiped chips each including plural LEDs (Light Emitting Diodes) (i.e., "LED array") are arranged on a board (this type of light emitting element module is hereinafter referred to as "LED module").

When an LED module is applied as a light emitting device, it is used as a light source for an LED print head for use in an electrophotographic printer, for example. On the other hand, when an LED module is applied as a light emitting device having a photosensitive (photodetecting) function as well as a light emitting function, the LED module is also usable as a reading/writing head for reading and writing characters, images, etc.

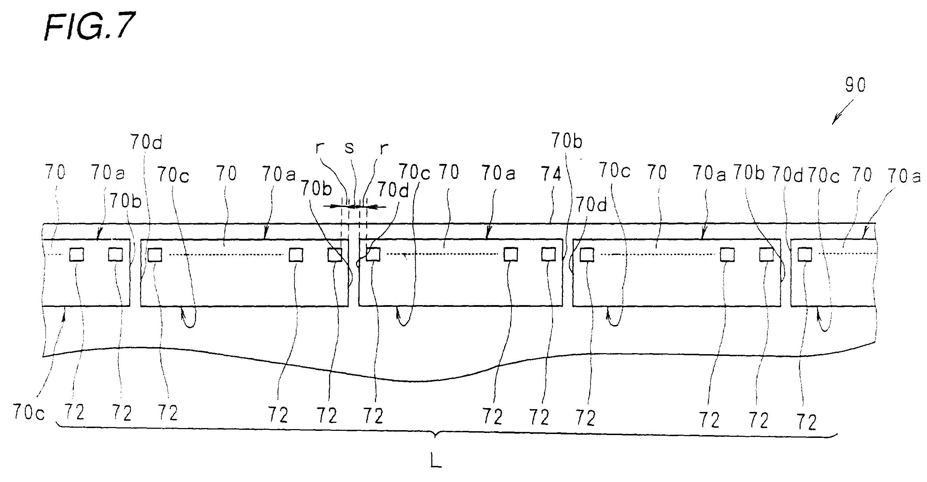

Fig. 7 is a plan view which schematically shows a general LED module, and shows rectangular chips 70 constituting the LED module and the periphery thereof. Each of the rectangular chips 70 has a first aide surface 70a, a second side surface 70b, a third side surface 70c and a fourth side surface 70d.

As shown in Fig. 7, each chip 70 has plural light emitting elements 72 which are arranged on the chip so as to be linearly aligned in a longitudinal direction of the chip and displaced (offset) from the longitudinal center line of the chip to one side of the chip. Here, the first side surface 70a is defined as one side surface of the chip 70 at which the light emitting elements 72 are arranged so as to be displaced (offset), and the second side surface 70b is defined as another side surface of the chip 70 which intersects to the first side surface 70a, the third side surface 70c is defined as another side surface of the chip 70 which is opposed to the first side surface 70a, and the fourth side surface 70d is defined as the residual side surface of the chip 70 which is located between the first side surface 70a and the third side surface 70c and intersects to both the first and third side surfaces 70a and 70c, that is, opposed to the second side surface 70b.

Accordingly, with respect to the chips 70 of the conventional LED module (light emitting element module), it is understood from Fig. 7 that all the plural light emitting elements 72 of each chip 70 having a substantially rectangular shape in plan view are disposed so as to be displaced (offset) from the center line of the chip 70 and located near to one side surface of the chip 70 (for example, the first side surface 70a), and also so as to be linearly aligned with one another.

Furthermore, the chips 70 are arranged at a predetermined chip interval on a board 74 so that an array line L is formed by the plural light emitting elements 72 placed on all the chips 70. In this case, the chips 70 are arranged on the board 74 so that the first side surface 70a of each chip 70 is located at one side area with respect to the array line L while the third side surface 70c of each chip 70 is located at the other side area with respect to the array line L (i.e., the first side surface 70a and the third side surface 70c are located at opposite sides with respect to the array line L as the boundary between both the side areas).

However, in the above-described conventional LED module (light emitting element module), the chips are arranged on the board so that the side surfaces of the neighboring chips are confronted to each other over the entire width of the side surface of the chips, that is, the chips are arranged so as to be completely aligned with one another in the longitudinal direction of the chips as shown in Fig. 7. Therefore, during the mount/demount process in which a chip is disposed at a predetermined position or a defective chip is removed from the board, there is a risk that the chip concerned would come into careless contact with neighboring chips to disturb the arrangement of the chips or damage the neighboring chips. Further, during the process in which a new chip is die-bonded to a portion from which a defective chip has been removed, there is also a risk that the new chip would come into careless contact with the neighboring chips to disturb the arrangement of the chips or damage the neighboring chips. Particularly when the light emitting elements are arrayed in higher density (i.e., the resolution of the LED module is higher), it is more difficult to keep sufficient the chip interval between the neighboring chips, and thus it is more and more difficult to arrange a chip at a predetermined position and remove a defective chip. This will be described in more detail with reference to Fig. 7 which shows the conventional LED module.

In Fig. 7, r represents the chip edge margin, and s represents the inter-chip distance. The following table shows the possible maximum inter-chip distance s for the chip edge margins of 4 *µ*m and 8 *µ*m when the resolution of the LED module is set to 400DPI, 600DPI, 1200DPI and 2400DPI.

| **MAXIMUM INTER-CHIP DISTANCEs** | | |
|---|---|---|
| | chip edge margin = 4 *µ*m | chip edge margin = 8 *µ*m |
| 400DPI | 55.5 *µ*m | 47.5 *µ*m |
| 600DPI | 34.3 *µ*m | 26.3 *µ*m |
| 1200DPI | 13.0 *µ*m | 5.0 *µ*m |
| 2400DPI | 2.5 *µm* | unable |

It is readily understood from the above table that as the resolution of the LED module is increased, the possible maximum inter-chip distance s is reduced. It is possible to mark each chip with an alignment mark and optically arrange each chip at a predetermined position while monitoring the mark, however, this technique also has a limitation in positioning of the chips.

Accordingly, as the light emitting elements of the LED module are arranged in higher density (as the resolution of the LED module increases) as described above, the probability that the arrangement of the neighboring chips is disturbed or the neighboring chips are damaged is more increased when a chip is disposed at a predetermined position or a defective chip is removed. Likewise, when a new chip is die-bonded to a portion from which a defective chip has been removed, the probability that the arrangement of the neighboring chips is disturbed or the neighboring chips are damaged is also more increased.

### SUMMARY OF THE INVENTION

Therefore, the present invention has an object to provide a light emitting element module which can readily and quickly perform a process for arranging a chip at a predetermined position and a process for replacing a defective chip with a new chip even when the light emitting elements are arranged in high density (for example, 400 to 2400DPI) on each chip of the light emitting element module (for example, LED module).

Furthermore, the presents invention has another object to provide a light emitting element module and chips used for the light emitting element module, which can effectively prevent the printing characteristics from being deteriorated due to leakage of the light from the chip edge side surface even when the array of the light emitting elements of the light emitting element module is highly densified, and allow the margin of the inter-chip distance to be large.

In order to attain the above objects, according to a first aspect of the present invention, a light emitting element module having plural chips arranged on a board, each chip having plural light emitting elements, is characterized in that the plural light emitting elements are arranged on each chip so as to be displaced from the center line of the chip to one side surface of the chip (this one side surface is hereinafter referred to as "first side surface"), that is, the light emitting elements are located in the vicinity of the first side surface of the chip, and also arranged along the first side surface of the chip, and also that the plural chips are arranged on the board so that at least two neighboring chips are displaced (offset) from each other to the opposite sides (right and left sides) with respect to the alignment of the light emitting elements thereof (i.e., the chips are in a staggered arrangement).

Therefore, according to the light emitting element module as described above, the plural chips are arranged such that the light emitting elements on all the chips form one arrangement line (i.e., the light emitting elements are arranged in straight alignment with one another), and at least two neighboring chips are displaced from each other to the opposite sides (right and left sides) with respect to the straight alignment of the light emitting elements so that the facing side surface of the neighboring chips are partially overlapped with each other in the alignment direction of the light emitting elements.

That is, irrespective of the displaced arrangement of the neighboring chips, the light emitting elements on the chips are straightforward aligned with one another to form substantially one arrangement line, so that the light emitting element module can implement a high-precision fight emitting function. In addition, the neighboring chips are arranged so as to be displaced from each other at least one position in the alignment direction of the light emitting elements, that is, there is provided at least one portion where the overlap area between the side surfaces of the neighboring chips is reduced, thereby enlarging the working space. The enlargement of the working space makes it possible to reduce the probability that the arrangement of neighboring chips is disturbed or neighboring chips are damaged when a chip is mounted at a predetermined position or a defective chip is replaced with a new one even when the arrangement of the light emitting elements is densified. Accordingly, the process of mounting at a predetermined position a chip having light emitting elements arranged in high density, and the process of replacing a defective chip with a new chip can be readily and quickly performed.

In the present invention, it is sufficient to provide at least one position where the overlap area between the side surfaces of neighboring chips is reduced (i.e., at least two neighboring chips which are displaced from each other to the opposite directions). This is because even when there is provided only one position where the overlap area between the side surfaces of the neighboring chips is reduced, the provision of such a position can enlarge the working space by the amount corresponding to the reduced area, so that the mount process of chips and the replacement process of defective chips can be readily and quickly performed.

Here, the light emitting element module is defined as a module which is constructed by arranging plural chips each having plural densified light emitting elements (i.e., light emitting element array) on a board. The light emitting element is defined as an element for emitting/detecting light in the vertical direction to the surface of the board. Further, the first side surface of the chip is one of the four side surfaces which define a chip having a rectangular shape in plan view, and it means one side surface of the chip to which the light emitting elements are located aside. Accordingly, when the planar shape of the chip is rectangular or parallelogrammatic, the first side surface of this chip corresponds to one of two longer sides of the chip.

Further, in the present invention, the provision of the light emitting elements in the vicinity of the first side surface means that the location (position) at which the light emitting elements are disposed is nearer to the first side surface. More specifically, the provision of the light emitting elements in the vicinity of the first side surface means that the light emitting elements are not brought into contact with the first side surface (that is, the surfaces of the light emitting elements and the first side surface are not on the same plane), and are disposed at a position (within a range) nearer to the first side surface of the chip than the longitudinal center line of the chip (for example, located at 350µm from the first side surface of the chip) when the chip (the length of the second side surface intersecting to the first side surface, for example, 700µm) is bisected along the arrangement line formed by the light emitting elements. In the light emitting element module of the present invention, considering as a margin the position (distance) at which the light emitting elements are disposed, it is preferable that the margin is set to a value in the range of about 1 to 100µm, and optimally the margin is set to a value in the range of about 3 to 10µm.

In the light emitting element module of the present invention, it is preferable that plural chips are disposed in a staggered arrangement. According to the staggered arrangement of the plural chips, the respective chips are alternately displaced (offset) to the opposite sides with respect to the longitudinal center line of the chips from one another on the board so that constant regularity is established in the arrangement. That is, the even-numbered chips are displaced (offset) to the one side surfaces (for example, the first side surfaces) thereof while the odd-numbered chips are displaced (offset) to the opposing side surfaces (for example, the third side surfaces) thereof so that the light emitting elements on the every chips are arranged in a straight line on the board. Accordingly, the overlap area between the second side surface (or the fourth side surface) of the odd-numbered chip and the second side surface (or the fourth side surface) of the even-numbered chip adjacent thereto is reduced, thereby enlarging the working space. Since the arranged chips are alternately and regularly displaced from one another as described above, there can be reduced the probability that the arrangement of the neighboring chips is disturbed or the neighboring chips are damaged when a chip is disposed at a predetermined position or a defective chip is replaced with a new one.

Furthermore, in the light emitting element module of the present invention, it is preferable that the respective light emitting elements form one arrangement line as a whole, and the first side surfaces of the odd-numbered chips from the edge of the chip alignment are located in one side area of the board with respect to the arrangement line while the first side surfaces of the even-numbered chips from the edge of the chip alignment are located in the other side area of the board with respect to the arrangement line.

With the above-described construction of the light emitting element module, a more uniform arrangement line can be constructed by the light emitting element module. Therefore, when the light emitting element module as described above is applied to an LED printer head or the like, the light emitting element module exerts its print function with high precision. In addition, the overlap area between the second side surface (or the four side surface) of each odd-numbered chip and the fourth side surface (or the second side surface) of each even-numbered chip can be surely reduced, resulting in enlargement of the working space.

Furthermore, in the light emitting element module of the present invention, it is preferable that the second side surface of the chip intersects to the first side surface at an angle other than 90° (not at the right angle).

By specifying the shape of the chips of the light emitting element module as described above, the margin (distance) between neighboring chips (between the odd-numbered chip from the edge of the chip alignment and the even-numbered chip from the edge of the chip alignment) can be increased.

Still further, in the light emitting element module of the present invention, it is preferable that the planar shape of each of said light emitting elements is set to a substantially parallelogram shape (containing no rectangular shape).

By specifying the shape of the chips of the light emitting element module as described above, the margin (distance) between neighboring chips (between the odd-numbered chip from the edge of the chip alignment and the even-numbered chip from the edge of the chip alignment) can be certainly increased.

Still further, in the light emitting element module of the present invention, it is preferable that the planar shape of the chips is substantially parallelogrammatic (containing no rectangle). By specifying the shape of the chips of the light emitting element module as described above, the margin (distance) between neighboring chips (the odd-numbered chip and the even-numbered chip from the edge of the chip alignment) can be surely increased.

In addition, it is preferable that the planar shape of the light emitting elements of the chips is substantially parallelogrammatic. By specifying the shape of the light emitting elements of the chips of the light emitting element module as described above, the distance from the side surface (at the edge side of the chip) of a light emitting element located at the edge portion of a chip to the second side surface (or the fourth side surface) of the chip can be increased.

Further, in the light emitting element module of the present invention, the side surface of each chip and the side surface of each light emitting element are preferably set to be substantially parallel to each other.

The side surface of each chip and the side surface of each light emitting element in the light emitting element module are matched with each other in shape as described above, thereby further increasing the distance from the side surface (at the edge side of the chip) of a light emitting element located at the edge portion of a chip to the second side surface (or fourth side surface) of the chip.

In the light emitting element module of the present invention, the light emitting elements of the chips are preferably composed of LEDs (Light Emitting Diodes). This is because although the LED is small in dimension, it has a large light emission amount, and thus it is suitable for the light emitting element module.

In the light emitting element module of the present invention, it is preferable that each of the light emitting elements of the chips has both a light emitting function (i.e., acts as a light emitter) and a photosensing (light receiving) function (i.e., acts as a photodetector).

If each light emitting element has both the light emitting function and the photosensing function as described above, when it is applied to an LED printer head or the like, there can be provided a reading/writing head for which the mount process for mounting a chip having light emitting elements and a repairing process for repairing a chip can be readily performed.

Further, in the light emitting element module of the present invention, each of the light emitting elements of the chips preferably performs the switching operation between the light emitting function and the photosensing function thereof by changing the applying direction of a bias voltage to the light emitting element (i.e., by selectively applying the bias voltage forwardly or reversely).

According to the construction of the light emitting elements of the chips as described above, both the light emitting function and the photosensing function can be readily provided to the light emitting element module of the present invention, no special device is needed and the light emitting element module can be designed in compact size.

Still further, the light emitting element module of the present invention is preferably used as a light source for an LED printer head. When the light emitting element module of the present invention is used as a light source for an LED printer head, the light emitting elements can be arranged in high density on the chips, and the chips having the highly-densified light emitting elements can be readily mounted on the board, so that the manufacturing process of LED printer heads is facilitated. In addition, there can be reduced the probability that the arrangement of adjacent chips is disturbed or the adjacent chips are damaged even when a defective chip is replaced with a new one or repaired. Accordingly, there can be readily and quickly performed the chip mount process for mounting a chip at a predetermined position and the chip replacement process for replacing a defective chip with a new one in a manufacturing or repairing process of a light source of a high-density LED printer head.

The light emitting element module of the present invention is preferably used as a print head or a reading/writing head for an LED printer head. The light emitting element module of the present invention is suitably used as a printing head or a reading/writing head for an LED printer head because the light emitting elements can be designed in high density, the manufacturing process of the light emitting element module itself is easy, and each of the light emitting elements can be provided with both the light emitting function and the photosensing function.

According to a second aspect of the present invention, a chip having plural light emitting elements is characterized in that when one side surface of the chip is referred to as a first side surface and another side surface of the chip which intersects to the first side surface is referred to a second side surface, the light emitting elements are provided in the vicinity of the first side surface of the chip so as to be located along and aside to the first side surface of the chip, and the second side surface of the chip intersects to the first side surface thereof at an angle other than 90°.

A plurality of chips thus constructed are arranged so as to be alternately displaced from one another, for example, they are disposed in a staggered arrangement so that the highly densely packed light emitting elements form one arrangement line (i.e., the light emitting elements are arranged in a straight alignment with one another), and the odd-numbered chips and the even-numbered chips from the edge of the chip alignment are arranged so that the facing side surface of these chips are partially overlapped in the chip alignment direction. That is, the light emitting element module which has an enlarged working space and is provided with highly densely packed light emitting elements can be constructed by using the above chips. Accordingly, it is possible to reduce the probability that when a chip is mounted at a predetermined position or a defective chip is replaced with a new one, the arrangement of the adjacent chips is disturbed or the adjacent chips are damaged. Thus, the chip mount process for mounting a chip at a predetermined position and the chip replacement process for replacing a defective chip with a new one can be readily and quickly performed.

It is preferable that the chip of the present invention is designed to be substantially parallelogram (containing no rectangle) in plan view. By specifying the shape of the chip as described above, under the same condition that the margin of the chip edge is constant, the margin of the inter-chip distance is longer than the case where the second side surface of each chip intersects to the first side surface thereof vertically. As the margin of the inter-chip distance is increased, the mount degree of each chip on the board is enhanced, resulting in facilitation of the chip mount process and the chip replacement process.

Furthermore, with the chip of the present invention, it is preferable that the light emitting elements of the chip are designed to be substantially parallelogrammatic (containing no rectangular shape) in plan view. By specifying the shape of the light emitting elements of the chip as described above, the distance from the side surface (at the edge side of the chip) of the light emitting element located at the edge portion of each chip to the second side surface (or fourth side surface) of the chip can be increased.

By matching the shapes of the side surfaces of the chips and the side surfaces of the light emitting elements as described above, the distance from the side surface (at the edge side of the chip) of the light emitting element located at the edge portion of each chip to the second side surface (or fourth side surface) of the chip can be more increased.

Still further, with the chip of the present invention, it is preferable that each light emitting element of the chip is provided with both the light emitting function and the photosensing (photodetecting) function. In this case, when the chip is applied to an LED printer head or the like, there can be provided a reading and writing head for which the manufacturing process and the repairing process can be readily performed.

With the chip of the present invention, it is preferable that each light emitting element of the chip performs the switching operation between the light emitting function and the photosensing function by changing the bias-voltage applying direction in the chip. By constructing the light emitting elements of the chip as described above, the light emitting element module of the present invention can be readily provided with both the light emitting function and the photosensing function with no special device, and also the light emitting element module can be miniaturized.

### BRIEF DESCRIPTION OF THE DRAWINGS

The foregoings and other objects features and advantages of the present invention will be better understood from the following description taken in connection with the accompanying drawings; in which:
Figs. 1(A) and 1(B) are diagrams showing an LED module according to a first embodiment of the present invention;
Fig. 2 is an enlarged view of a part of the LED module according to the first embodiment of the present invention;
Fig. 3 is an exploded view showing an LED printer head when the LED module of the first embodiment of the present invention is used for the LED printer head;
Figs. 4(A) and 4(B) are diagrams showing an LED module according to a second embodiment of the present invention;
Fig. 5 is an enlarged view showing a part of the LED module of the second embodiment shown in Figs. 4(A) and 4(B);
Fig. 6 is a schematic diagram showing the comparison between the inter-chip distance of the LED module of the second embodiment and the inter-chip distance of the LED module of the first embodiment according to the present invention; and
Fig. 7 is a plan view which schematically shows a general LED module.

### DETAILED DESCRIPTION OF THE PREFERRED EMBODIMENTS

Preferred embodiments according to the present invention will be described hereunder in detail with reference to the accompanying drawings.

In the accompanying drawings, the respective constituent elements of the present invention are illustrated schematically to the extent that the shape, the size and the arrangement relationship thereof are understandable. Accordingly, the present invention is not limited to the illustration of the drawings unless otherwise specified. Further, the same or similar elements in the drawings are represented by the same reference numerals, and the duplicative description thereof is omitted.

In the following embodiments, an LED module (LED printer head) which is one type of light emitting element modules will be typically represented, and an embodiment of a chip will be also described together in a second embodiment.

### 〈First Embodiment〉

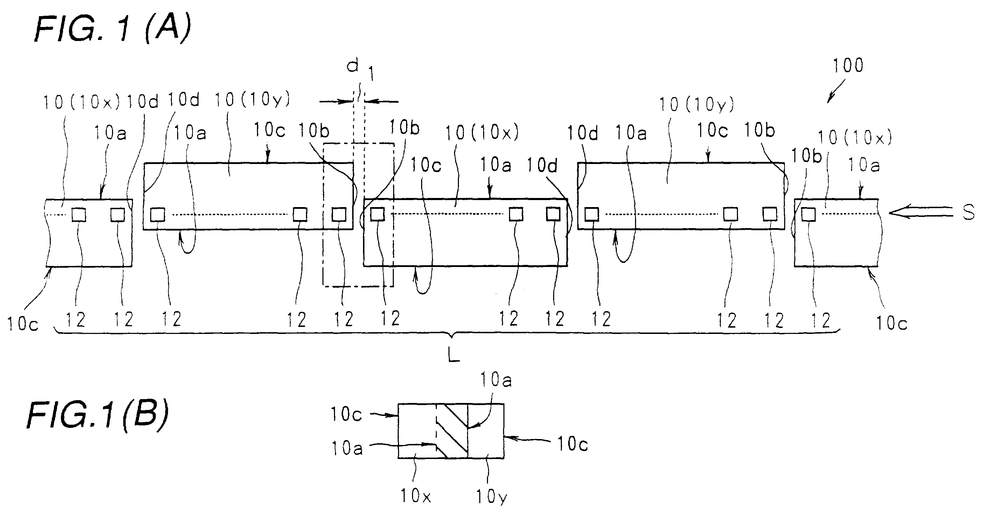

Figs. 1(A) and 1(B), Fig. 2 and Fig. 3 show an LED module (LED printer head) of a first embodiment according to the present invention.

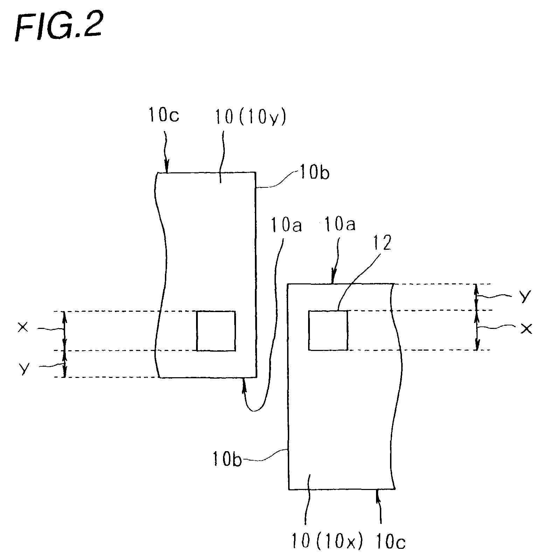

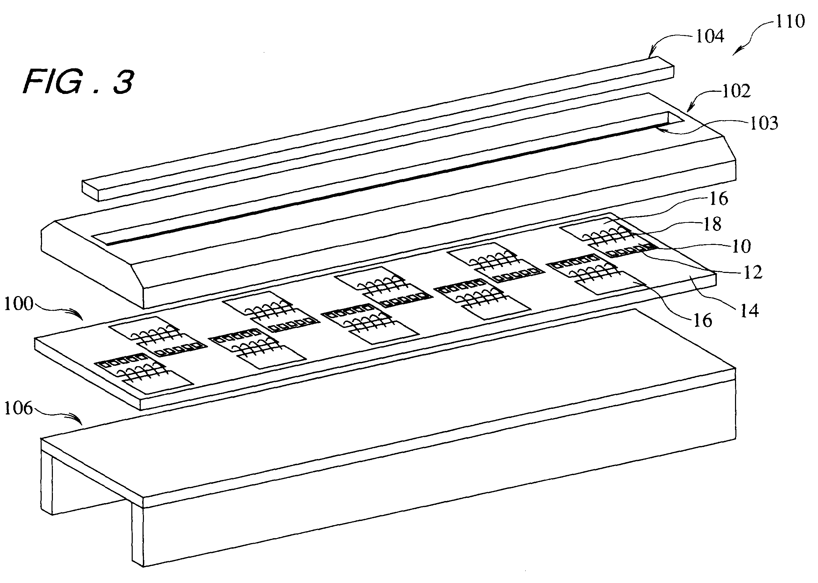

Fig. 1(A) is a plan view showing the LED module, and also shows a chip serving as a part constituting the LED module and the periphery thereof and Fig. 1(B) is a side view showing the LED module which is taken in the direction of S in Fig. 1(A). Fig. 2 is an enlarged view showing a part which is surrounded by a one-dotted broken line in Fig. 1(A), and Fig. 3 is an exploded view when the LED module shown in Figs. 1 and Fig. 2 is used as a part of an LED printer head. In Figs. 1 and 2, electrodes, a board, etc. are omitted from the illustration of the LED module.

In this embodiment, a generally-used rectangular chip (for example, 700µm in longitudinal direction (the length of the second and the fourth side surfaces), 8000µm in lateral direction (the length of the first and third side surfaces), 300µm in height) is used.

As shown in Fig. 1(A), each chip 10 is provided with plural light emitting elements 12 which are arrayed in high density. All the light emitting elements 12 are arranged aside in the vicinity of the first side surfaces 10a of the chips so as to be in straight alignment with one another along the first side surfaces 10a. Each chip 10 comprises the first side surface 10a, the second side surface 10b, the third side surface 10c and the fourth side surface 10d.

As described as in the case of the conventional prior art, one side surface of each chip along which the light emitting elements 12 are located is referred to as a first side surface 10a. Further, another side surface of each chip which intersects to the first side surface 10a is referred to as a second side surface 10b. Another side surface of each chip which is opposed to the first side surface 10a is referred to as a third side surface 10c, and the residual side surface of each chip which is opposed to the second side surface 10b is referred to as a fourth side surface 10d.

As shown in Fig. 1(A), the chips 10 are arranged (disposed) so that the distance between the neighboring chips 10 (the inter-chip distance) d₁ is fixed. In addition, the chips 10 are arranged (disposed) on the board so that the neighboring chips arc alternately displaced (offset) from each other (i.e., the chips are disposed in a staggered arrangement) and the plural light emitting elements 12 provided to the respective chips 10 are aligned with one another to form an arrangement line L (a row of the light emitting elements 12).

In this case, one half group of chips which contain the leftmost chip and subsequent every other chips from the left edge of the chip alignment are set as odd-numbered chips 10x as shown in Fig. 1(A). Further, the other half group which contain the second chip from the left side and subsequent every other chips are set as even-numbered chips 10y as shown in Fig. 1(B). Accordingly, the first side surfaces 10a of the odd-numbered chips 10x are located in one side area with respect to the arrangement line L of the light emitting elements 12 (in Fig. 1(A), the upper side area of the arrangement line L of the light emitting elements), and the first side surfaces 10a of the even-numbered chips 10y are located in the other side area with respect to the arrangement line L of the light emitting elements 12 (in Fig. 1(A), the lower side area of the arrangement line L of the light emitting elements).

When the chips 10 are arranged as described above, the odd-numbered chips 10x and the even-numbered chips 10y are arranged so as to be offset in the opposite directions with respect to the arrangement line L of the light emitting elements 12. That is, the direction from the first side surface 10a to the third side surface 10c is opposite between the odd-numbered chips 10x and the even-numbered chips 10y. Further, when the side surface of the LED module 100 is viewed along the extension line of the arrangement line L of the light emitting elements 12, each odd-numbered chip 10x and each even-numbered chip 10y are partially overlapped with each other as shown in Fig. 1(B) (the overlap area between the odd-numbered chip 10x and the even-numbered chip 10y is hatched in Fig. 1(B). That is, the chips are partially overlapped with each other between the first side surface 10a of each odd-numbered chip 10x and the first side surface 10a of each even-numbered chip 10y.

The reduction of the overlap area between the neighboring chips as described above enables the working space to be enlarged. Accordingly, there can be eliminated portions at which the disturbance of the arrangement of the neighboring chips or the damage of the neighboring chips can be suppressed even when a chip is mounted at a predetermined position on a board or a defective chip is replaced with a new one. Thus, the chip mount process for mounting a chip at a predetermined position and the chip replacement process for replacing a defective chip with a new one can be readily and quickly performed.

As described above, the chip has a rectangular parallelepiped body having the size of 700µm in longitudinal direction, 8000µm in lateral direction and 300µm in height, and the light emitting elements are linearly aligned with one another along the side surface (first side surface 10a) of 8000µm x 300mµ in dimension on the surface of the chip having the size of 700µm x 8000µm.

In the above case, the light emitting elements are linearly aligned with one another, however, the light emitting elements may be arranged on two or more rows. This arrangement is preferable because the area of the light emitting elements is larger as a whole.

Further, it is assumed that each light emitting element 12 is a square whose side length is equal to 8µm as shown in Fig. 2, and the distance y from the first side surface 10a to each light emitting element 12 is set to 6µm. In this case, when viewing the side surface of the LED module along the extension line of the arrangement line L of the light emitting elements 12 (that is, when viewing the side surface of the LED module 100 from the direction of S in Fig. 1(A)), the area of the overlap portion between the odd-numbered chip 10x and the even-numbered chip 10y is equal to (6µm + 8µm +6µm) x 300µm = 6000µm².

On the other hand, when the chips are disposed in such a linear arrangement as utilized in the prior art, the area of the overlap portion between the odd-numbered chip 10x and the even-numbered chip 10y is equal to 700µm x 300µm = 210000µm².

Accordingly, when the respective chips are arranged as described in the above embodiment, it is understood that the overlap area between the neighboring chips can be reduced to 1/35 of that of the prior art in which the chips are arranged so that the side surfaces thereof are overlapped with one another over the full width thereof.

In the present invention, when the area of the overlap portion between the side surfaces of the respective chips when the side surfaces are fully overlapped with one another is set to 100%, the ratio of the overlap portion is preferably set to 50% or less at maximum, more preferably 25% or less, and optimally 5% or less.

If the overlap area between the neighboring chips is set to a value within the above range, the working space can be enlarged. Accordingly, even when the light emitting elements are arranged in a high density in the LED module 100, the chips 10 can be successively readily and quickly arranged on the board 14 by a die-bonding technique or the like. Further, the chip mount process and the chip replacing (the chip repairing) process can be also readily and quickly performed.

Fig. 3 is an exploded view showing an LED printer head 110 when the LED module 100 is used as a part of the LED printer head 110 as shown in Figs. 1 and 2.

The LED printer head 110 comprises a support portion 106, an LED module 100, a rod lens array holder 102 and a rod lens array 104 from the lower side. The support portion 106 serves to mechanically hold the LED module 100, and also serves as a heat sink for radiating heat which occurs in the LED module 100. The rod lens array holder 102 is directly provided at the upper side of the LED module 100 to accurately position the rod lens array 104 which is mounted in the opening 103 of the holder 102. The rod lens array 104 serves to efficiently focus an LED image onto a photosensitive member.

As described above, the LED module 100 uses the chips each having the light emitting elements 12 which are located aside to the first side surface 10a of the chip 10 and on the surface of the chip, and arranged along the first side surface 10a. In addition, a plurality of these chips 10 are arranged on the board 14 while alternately displaced (offset) from one another (in a staggered arrangement).

Further, an IC driver 16 for driving a chip is provided on the board 14 of the LED module 100 in association with each chip. Each light emitting element 12 on the surface of each chip 10 is electrically connected to each terminal of the IC driver 16 by a bonding wire 18. Accordingly, in the LED printer head 110 thus constructed, each IC driver 16 controls each light emitting element 12 to exhibit its light emitting function, and data are printed on a photosensitive member through the rod lens array 104.

That is, according to the LED module 100 which constitutes a part of the LED printer head 110, the overlap area between the neighboring chips 10 is reduced, and the working space is enlarged. Accordingly, when the LED printer head 110 is constructed, a highly densified (for example, 400 to 2400DPI) chip 10 can be readily and quickly mounted at a predetermined position. In addition, even when a defective chip occurs due to use of the LED printer head 110, the chip can be readily and quickly replaced with a new one.

### 〈Second Embodiment〉

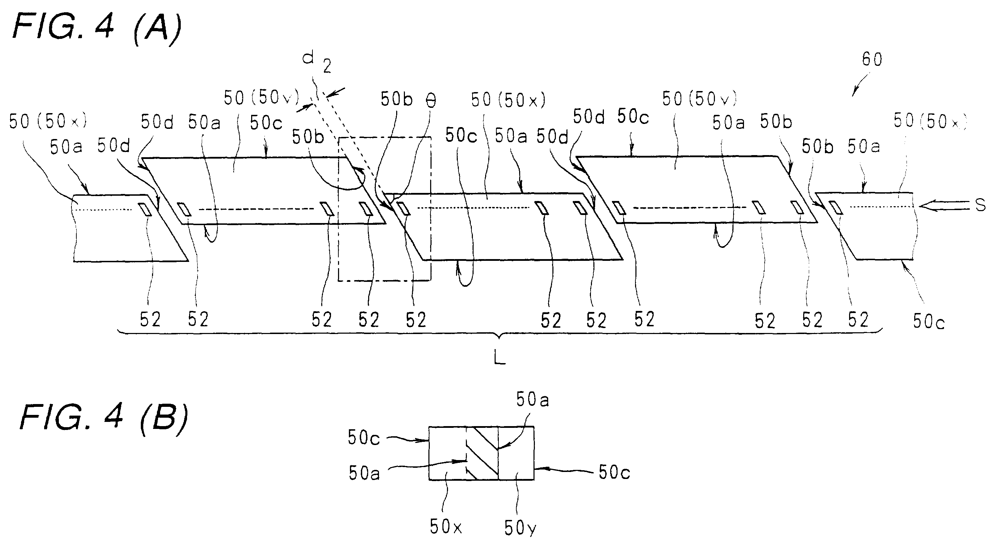

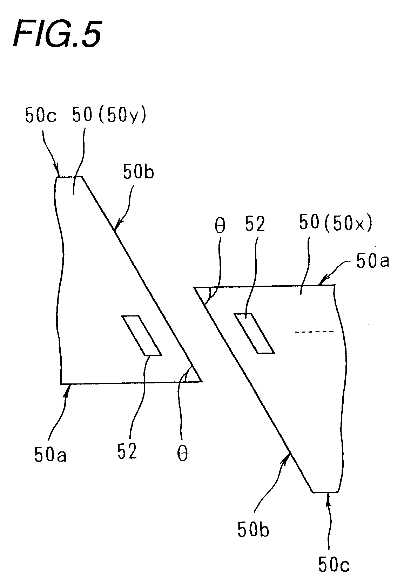

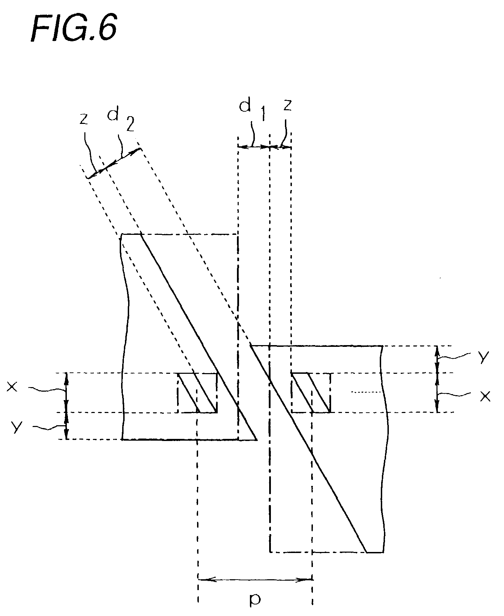

Figs. 4(A) and 4(B) , Fig. 5 and Fig. 6 show an LED module according to a second embodiment of the present invention. Fig. 4(A) is a schematic plan view showing the LED module, and shows a chip constituting a part of the LED module and the periphery thereof. Fig. 4(A) is a side view showing the LED module, which is viewed from the direction of S in Fig. 4(A). Fig. 5 is an enlarged view showing a part surrounded by a one-dotted broken line in Fig. 4(A). Fig. 6 is a schematic diagram to show the comparison result between the inter-chip distance of the LED module of the second embodiment and the inter-chip distance of the LED module of the first embodiment. In the figures, electrodes, a board, etc. are omitted from the illustration.

As shown in Fig. 4(A), each chip 50 is provided with plural light emitting elements 52 which are arranged in high density, and the light emitting elements 52 are located aside to the first side surfaces 50a of all the chips 50 and linearly aligned with one another along the first side surfaces 50a. The side surface of each chip 50 which intersects to the first side surface of the chip, that is, the second side surface 50b which faces the adjacent chip is set to intersect to the first side surface 50a at an angle other than 90°. Accordingly, the second side surface 50b serves as the chip edge which faces the adjacent chip.

For example, in the case where the chip edge margin z is set to 4µm and the dot pitch p is set to 21µm, the inter-chip distance is maximum second side surface 50b when the intersection angle Θ between the second side surface 50b and the first side surface 50a is equal to 60°. For the convenience's sake of the description, the second embodiment will be described on the assumption that the second side surface 50b intersects to the first side surface 50a at an angle θ of 60°.

Further, as shown in Fig. 5, the light emitting element which is located nearest to the second side surface 50b of each chip 50 (hereinafter referred to as "chip edge light emitting element") is designed in a parallelogram shape in plan view, and the outline (contour) of the chip edge light emitting element 52 at the second side surface 50b side is parallel to the second side surface 50b.

In the second embodiment, the planar shape of the chip edge light emitting element 52 is set to be parallelogrammatic (excluding rectangle), however, it is not limited to the parallelogrammatic shape. The planar shape may be triangular, trapezoidal, semi-circular or the like insofar as the second side surface (outline) of the chip edge light emitting element is parallel to the second side surface (outline) of the chip. Further, when the planar shape of the light emitting element is set to a shape other than the square and the rectangle, the minimum square or rectangle in which the light emitting element is accommodated (one side of the square or the rectangle must be parallel to the first side surface is assumed, and the dot pitch from the intersection point between the diagonal lines of the square or the rectangle to the adjacent light emitting element is measured.

Further, as shown in Fig. 4(A), the chips 50 are disposed on the board 54 so that the inter-chip distance d₂ is constant, and also these chips 50 are arranged on the board so that the arrangement line L (the array of the light emitting elements 52) is formed by plural light emitting elements 52 which are provided to the chips 50 (i.e., the plural light emitting elements are linearly aligned with one another to form the arrangement line L). In this case, the leftmost chip and subsequent every other chips from the leftmost chip are set as odd-numbered chips 50x while the second chip from the left edge of the chip alignment and subsequent every other chips are set as even-numbered chips 50y.

Accordingly, the first side surfaces 50a of the odd-numbered chips 50x are located in one side area with respect to the arrangement line L of the light emitting elements 52 on the board (print circuit board) 54 (the upper side area of the arrangement line L of the light emitting elements 52 in Fig. 4(A)). Further, the first side surfaces 50a of the even-numbered chips 50y are located in the other side area with respect to the arrangement line L of the light emitting element 52 on the board 54 (the lower side area of the arrangement line L of the light emitting elements 52 in Fig. 4(A)).

In the case where the respective chips 50 are arranged as described above, each odd-numbered chip 50x and each even-numbered chip 50y are partially overlapped with each other when the side surface of the LED module 60 is viewed along the extension line of the arrangement line L of the light emitting elements 50 (in Fig. 4(B), the overlap area between the odd-numbered chip 50x and the even-numbered chip 50y is hatched). This arrangement would be readily understandable from the enlarged view (Fig. 5) of a portion which is surrounded by one-dotted broken line in Fig. 4(A). That is, with respect to the odd-numbered chip 50x and the even-numbered chip 50y which are adjacent to each other, as shown in Fig. 5, the second side surface 50b of the odd-numbered chip 50x and the second side surface 50b of the even-numbered chip 50y are partially overlapped with each other. In this case, the length of the second side surface 50b of the odd-numbered chip 50x (the second side surface 50b of the even-numbered chip 50y has the same length) is assumed as 100%, the overlap area between the neighboring chips corresponds to about 44%.

If the overlap area between the neighboring chips is reduced as described above, there can be removed portions at which the arrangement of the neighboring chips may be disturbed or the neighboring chips may be damaged when a chip is mounted at a predetermined position or a defective chip is replaced with a new one. Accordingly, the process for mounting a chip at a predetermined position and the process for replacing a defective chip with a new chip can be readily and quickly performed.

Fig. 6 shows the peripheries of the chip edges of two chips which are adjacent to each other in the LED module of the second embodiment, and also illustrates, with one dotted broken line, the LED module 60 of the second embodiment while superposing the LED module 60 of the second embodiment with the LED module 100 of the first embodiment under the condition of the same distance y from the first side surface 50a to the light emitting elements 52, the same chip edge margin z and the y same dot pitch p. That is, the illustrations of Figs. 2 and 5 are shown while overlapped with each other, and also Fig. 2 is illustrated by one-dotted broken line.

Fig. 6 shows the case where the distance y from the first side surface to the light emitting elements is set to 6µm, the chip edge margin z is set to 4µm, and the dot pitch p is set to 21µm. In the case of the LED module 100 of the first embodiment, the light emitting element is designed as a square having one side of 8µm, and the inter-chip distance d₁ is set to 5µm. On the other hand, in the case of the LED module 60 of the second embodiment, each side x of the minimum square in which the light emitting element is accommodated is set to 8µm. Since the second side surface 50b intersects to the first side surface 50a at an angle θ of 60° in the LED module 60 of the second embodiment, the inter-chip distance d₂ is equal to 7.2µm.

Accordingly, as in the case of the above embodiment, when the intersection angle Θ between the second side surface 50b and the first side surface 50a is set to 60°, and the side surface of the chip edge light emitting element 52a corresponding to the second side surface 50b of the chip 50 is set to be parallel to the second side surface 50b of the chip, the margin of the inter-chip distance is increased by about 1.4 times as compared with the first embodiment in which the side surface of the chip which faces the adjacent chip intersects to the first side surface at the right angle.

Accordingly, it is easy to understand that in spite of the high-density arrangement of the plural light emitting elements 52 (for example, 400 to 2400DP), the working space is enlarged, and both of the chip mount process for mounting a chip at a predetermined position and the chip replacement process for replacing a defective chip with a new one can be readily and quickly performed.

As in the case of the LED module 100 of the first embodiment, the LED module 60 of the second embodiment is also usable as a part of an LED printer head. That is, as described on the first embodiment (see Fig. 3), the LED printer head can be constructed by the LED module 60 of the second embodiment, the support member, the rod lens array holder and the rod lens array.

Accordingly, in the LED printer head which uses the LED module 60 of the second embodiment as a part thereof each IC driver controls each light emitting element to exhibit its light emitting function, whereby print can be performed on a photosensitive member through the rod lens array.

It is apparent that the present invention is not limited to the above-described first and second embodiments. For example, each of the above-described embodiments relates to an LED module which is mainly applied to an LED print head or the like. However, the present invention may be applied to an image sensor or the like which is constructed by arranging on a board chips each including plural PDs (photodiodes) as light emitting elements.

Furthermore, in the present invention, the light emitting elements are controlled to selectively exhibit one of the light emitting function and the photosensing function by switching the application direction of a bias voltage to chips, whereby the LED module can be applied to not only an LED printer head for print (exhibiting a print function), but also a reading head for reading information from a printed medium or the like, or a reading/writing LED print head.

As described above, according to the light emitting element module of the present invention, the light emitting element module is constructed by arranging on a board chips each of which comprises plural light emitting elements, and when one of the side surfaces of each chip is expressed as a first side surface, the respective light emitting elements are provided on each chip so as to be located aside to the first side surface of the chip, and the light emitting elements are arranged along the first side surface of the chip. In addition, the respective chips are arranged on the board so that one arrangement line is formed by the light emitting elements on all the chips, and the first side surfaces of the odd-numbered chips are located in one side area with respect to the arrangement line of the light emitting elements while the first side surfaces of the even-numbered chips are located in the other side area with respect to the arrangement line of the light emitting elements.

According to the light emitting element module thus constructed, each odd-numbered chip and each even-numbered chip are partially overlapped with each other when viewing the side surface of the light emitting element module along the extension line of the arrangement line of the light emitting elements. That is, the odd-numbered chip and the even-numbered chip are overlapped with each other only between the first side surface of the odd-numbered chip and the first side surface of the even-numbered chip, and the neighboring chips are aligned so that the side surfaces of the chips are partially confronted to each other (i.e., they are confronted to each other only at a narrow portion extending from the alignment of the light emitting elements to the first side surface.

Accordingly, the reduction of the overlap area between the neighboring chips as described above makes it possible to reduce the probability that when a chip is mounted at a predetermined position on the board or a defective chip is replaced with a new one, the arrangement of the adjacent chips would be disturbed or the adjacent chips would be damaged. That is, the process for mounting at a predetermined position a chip having light emitting elements which are arranged in high density, and the process for replacing a defective chip with a new one can be readily and quickly performed.

Furthermore, in the light emitting element module as described above, the confronting second side surfaces of the adjacent chips are set to intersect to the first side surfaces thereof at an angle other than 90° (not at the right angle). In addition, the light emitting element (chip edge light emitting element) which is nearest to the second side surface of each chip is set to be parallel to the second side surface. Accordingly, under the condition that the chip edge margin is fixed, the margin of the inter-chip distance is increased to a larger value as compared with the case where the second side surfaces of the adjacent chips which are confronted to each other are set to intersect to the first side surfaces thereof at the right angle. As the margin of the inter-chip distance is increased, the working space is enlarged, and the freedom of the chip mount on the board is enhanced. That is, a chip having plural light emitting elements which are arranged in high density can be more easily arranged with high precision.

## Claims

1. A light emitting element module (100, 60) in which plural chips (10, 50) each including plural light emitting elements (12, 52) are arranged on a board, characterized in that when one side surface of each of said chips is expressed as a first side surface (10a, 50a), said light emitting elements are located aside to and in the vicinity of said first side surface on the surface of said chip and arranged along the said first side surface of said chips, and said chips are arranged on the board so that at least two neighboring chips are displaced from each other to the right and left sides.

2. The light emitting element module as claimed in claim 1, wherein plural chips are disposed in a staggered arrangement.

3. The light emitting element module as claimed in claim 1, wherein said light emitting elements form one arrangement line as a whole, and the said chips are arranged so that the first side surfaces of odd-numbered chips(10x, 50x) from the end of the chip arrangement are located in one side area with respect to the arrangement line while the first side surfaces of even-numbered chips (10y, 50y) from the end of the chip arrangement are located in the other side area with respect to the arrangement line.

4. The light emitting element module as claimed in claim 1, wherein when a side surface (10b, 10d, 50b, 50d) of each chip which intersects to the first side surface of said chip is expressed as a second side surface, the second side surface of said chip intersects to the first side surface of said chip at an angle other than 90°.

5. The light emitting element module as claimed in claim 1, wherein the planar shape of each of said chips is set to a substantially parallelogram shape (containing no rectangular shape).

6. The light emitting element module as claimed in claim 1, wherein the planar shape of each of said light emitting elements is set to a substantially parallelogram shape (containing no rectangular shape).

7. The light emitting element module as claimed in claim 1, wherein the side surface of each of said chips and the side surface of each of said light emitting elements are set to be substantially parallel to each other.

8. The light emitting element module as claimed in claim 1, wherein each of said light emitting elements comprises an LED (Light Emitting Diode).

9. The light emitting element module as claimed in claim 1, wherein each of said light emitting elements has both a light emitting function and a photosensing function.

10. The light emitting element module as claimed in claim 1, wherein each of said light emitting elements selectively exhibits one of the light emitting function and the photosensing function by switching the applying direction of a bias voltage to said chips.

11. The light emitting element module as claimed in claim 1, wherein said light element module is used as a light source for an LED printer head.

12. The light emitting element module as claimed in claim 1, wherein said light emitting element module is used as a print head for an LED printer or a reading/writing head for an LED printer.

13. A chip having plural light emitting elements, characterized in that when one side surface of said chip is expressed as a first side surface and another side surface of said chip which intersects to the first side surface is expressed as a second side surface, said light emitting elements are located aside to and in the vicinity of the first side surface of said chip, and are arranged along the first side surface, and that the second side surface intersects to the first side surface at an angle other than 90°.

14. The chip as claimed in claim 13, wherein the planar shape of said chip is set to a substantially parallelogram shape (containing no rectangular shape).

15. The chip as claimed in claim 13, wherein the planar shape of each of said light emitting elements is set to a substantially parallelogram shape (containing no rectangular shape).

16. The chip as claimed in claim 13, wherein the side surface of said chip and the side surface of each of said light emitting elements are substantially parallel to each other.

17. The chip as claimed in claim 13, wherein each of said light emitting elements are provided with both a light emitting function and a photosensing function.

18. The chip as claimed in claim 13, wherein each of said light emitting elements selectively exhibits one of the light emitting function and the photosensing function by switching the applying direction of a bias voltage to said chips.
